# EUROPÄISCHE PATENTANMELDUNG

(11) **EP 4 693 902 A1**
(43) Veröffentlichungstag der Anmeldung: **11.02.2026**
(21) Anmeldenummer: 25194007.8
(22) Anmeldetag: 05.08.2025
(51) Int. Cl.: H03K 3/53, H03K 5/06, F41H 13/00

(54) **JITTERFREIES HPEM-DS-ARRAY**

(30) Priorität: 08.08.2024 DE 102024002565
(71) Anmelder: Diehl Defence GmbH & Co. KG, 88662 Überlingen (DE)
(72) Erfinder: Urban, Jürgen, 91056 Erlangen (DE); Heinlein, Dieter, 90537 Feucht (DE)
(74) Vertreter: Diehl Patentabteilung

(57) **Zusammenfassung**

Ein Array (2) zur Aussendung eines HPEM-DS-Gesamtpulses (4) als Summe von HPEM-DS-Teilpulsen (6a-d) enthält Einzelmodule (8a-d) als Reihenschaltung aus einem funkenstreckenfreien Pulsgenerator (10a-d) für Quellpulse (12a-d), einem funkenstreckenfreien Resonator (14a-d) zur Formung von Teilpulsen (6a-d) aus den Quellpulsen (12a-d), einem Richtkoppler (18a-d) zur Auskopplung eines Messsignals (20a-d) aus den Teilpulsen (6a-d), und einer Antenne (22a-d) zur Abstrahlung der Teilpulse (6a-d), mit je einem Triggereingang (24a-d) zur Auslösung der Pulsgeneratoren (10a-d) anhand von Triggersignalen (26a-d), und ein Triggermodul (28), um für einen Gesamtpuls (4) die Triggersignale (26a-d) anhand der rückgekoppelten Messsignale (20a-d) in einer zeitlichen Triggerfolge (30) derart bereitzustellen, dass die Teilpulse (6a-d) in einer gewünschten zeitlichen Sendefolge (32) zueinander abgestrahlt sind.

Bei einem Verfahren zum Betreiben des Arrays (2) stellt das Triggermodul (28) für den Gesamtpuls (4) die Triggersignale (26a-d) anhand der rückgekoppelten Messsignale (20a-d) in der zeitlichen Triggerfolge (30) derart bereit, dass die Teilpulse (6a-d) in der gewünschten zeitlichen Sendefolge (32) zueinander abgestrahlt werden.

## Beschreibung

Die Erfindung betrifft die Erzeugung eines HPEM-DS-Pulses (High Power Elektromagnetics - Damped Sinusoidal, gedämpfter Sinus).

Aus der EP 4 148 988 A1 ist ein Pulsgenerator bekannt zur Erzeugung eines HPEM-Pulses, mit einem Marx-Generator mit mehreren Kondensatoren, die zwischen zwei Ausgangspolen in Reihe geschaltet sind, wobei beim Betrieb des Marx-Generators zwischen den Ausgangspolen eine Marxspannung bereitgestellt ist, mit einem DS-Resonator mit zwei Eingangspolen, wobei jeder der Eingangspole über eine jeweilige Zuleitung mit einem der Ausgangspole verbunden ist, wobei die Kondensatoren räumlich entlang einer Verlaufslinie angeordnet sind, an deren beiden Enden sich jeweils einer der Ausgangspole befindet, wobei der Abstand zwischen den Ausgangspolen kleiner als die Längsausdehnung des Marx-Generators entlang der Verlaufslinie ist.

Aufgabe der vorliegenden Erfindung ist es, Verbesserungen in Bezug auf die Erzeugung eines HPEM-DS-Pulses vorzuschlagen.

Die Aufgabe wird gelöst durch ein Array gemäß Patentanspruch 1. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Das Array ist eingerichtet bzw. dient zur Aussendung eines HPEM-DS-Pulses in Form eines HPEM-DS-Gesamtpulses. "Gesamt"-Puls, da dieser eine Summe bzw. Überlagerung von HPEM-DS-Teilpulsen ist.

Das Array enthält mindestens zwei Einzelmodule. Jedes dient zur Erzeugung eines der Teilpulse als Teil eines jeweiligen Gesamtpulses. Jedes der Einzelmodule ist eine Reihenschaltung, die wie folgt ausgeführt ist:
Am Beginn (Richtung eines Signal- bzw. Leistungsflusses) der Reihenschaltung befindet sich ein funkenstreckenfreien Pulsgenerator. Dieser dient bzw. ist eingerichtet zur Erzeugung eines Quellpulses. Der Quellpuls ist hierbei insbesondere ein unipolarer Quellpuls.

Nächstes Element in der Reihenschaltung ist ein funkenstreckenfreier Resonator. Dieser dient bzw. ist eingerichtet zur Formung eines jeweiligen Teilpulses aus dem jeweiligen Quellpuls. Der Teilpuls ist insbesondere bipolarer Teilpuls.

In der Reihenschaltung dem Resonator wiederum nachgeschaltet befindet sich ein Richtkoppler. Dieser dient zur Auskopplung eines Teils des Teilpulses als Messsignal. Der ausgekoppelte Teil ist hierbei insbesondere ein unwesentlicher Teil von z.B. höchstens -20 oder höchstens -30 oder höchstens -40dB. Somit steht der Teilpuls praktisch unverändert und in voller Höhe bzw. Leistung auch nach der Auskopplung zur Weiterleitung in der Reihenschaltung zur Verfügung.

Am Ende der Reihenschaltung und damit dem Richtkoppler nachgeschaltet befindet sich eine Antenne. Diese dient zur Abstrahlung des Teilpulses in Form elektromagnetischer Strahlung. Sämtliche miteinander abgestrahlten Teilpulse aller Einzelmodule addieren bzw. überlagern sich dann zum Gesamtpuls.

In Bezug auf die Antenne wird also streng genommen nur der "restliche" Teilpuls (also ohne das ausgekoppelte Messsignal) abgestrahlt. Der Einfachheit halber wird jedoch hier auch von dem "Teilpuls" gesprochen, da wie oben erwähnt nur ein unwesentlicher Teil dessen als Messsignal ausgekoppelt wird bzw. ist.

In Bezug auf den Gesamtpuls gesehen bilden die Einzelmodule somit sinngemäß parallelgeschaltete Zweige des Arrays, die parallel zueinander jeweilige Teilpulse erzeugen, welche dann von den Antennen abgestrahlt werden und im Betrieb damit als Summenpuls den HPEM-DS-Gesamtpulses bilden.

Jedes der Einzelmodule, insbesondere dessen Pulsgenerator, weist einen Triggereingang auf. Dieser dient bzw. ist eingerichtet zum Empfang eines Triggersignals. Das Triggersignal bzw. der Triggereingang dienen somit zur Auslösung des jeweiligen Pulsgenerators, d.h. zur Auslösung der Erzeugung des Quellpulses und damit schlussendlich des jeweiligen Teilpulses.

Das Array enthält ein Triggermodul. Das Triggermodul bzw. dessen nicht näher erläuterte Triggerausgänge sind auf je einen Triggereingang der Einzelmodule geführt.

Das Triggermodul ist dazu eingerichtet, für einen jeweiligen der Gesamtpulse die zu dessen Erzeugung dienenden Triggersignale bereitzustellen. Die Bereitstellung erfolgt dabei anhand wenigstens eines, insbesondere mehrerer oder aller, der schlussendlich auf das Triggermodul rückgekoppelten Messsignale. Die Bereitstellung der Triggersignale erfolgt in einer zeitlichen Triggerfolge. Die Triggerfolge bestimmt also die zeitliche Korrelation der einzelnen Triggersignale zueinander.

Der Begriff "Folge" ist hier weit zu verstehen und schließt auch die Möglichkeit ein, dass Triggersignale nicht nur tatsächlich zu verschiedenen Zeitpunkten zeitlich aufeinander "folgen", sondern dass zwei oder mehrere oder alle Triggersignale auch gleichzeitig auftreten / beginnen / liegen können.

Die Bereitstellung der Triggersignale als Triggerfolge erfolgt derart, dass die Teilpulse in einer gewünschten zeitlichen Sendefolge zueinander abgestrahlt sind bzw. werden. Auch bezüglich der Sendefolge gilt, dass "Folge" hier weit im obigen Sinne zu verstehen ist, also Gleichzeitigkeit von zwei oder mehr Teilpulsen einschließt. Insbesondere werden z.B. alle Teilpulse gleichzeitig von den Antennen abgestrahlt.

Die Aussendung der Teilpulse in der Sendefolge bedeutet, dass eine gewünschte absolute zeitliche Korrelation der jeweiligen ersten Pulsflanken der Teilpulse geschaffen wird. Hierbei handelt es sich um eine absolute Zeitkorrelation, zum Beispiel Gleichzeitigkeit oder Zeitversatz der ersten Flanken und damit der Gesamtpulse. Die Sendefolge bzw. zeitliche Korrelation bezieht sich also nicht (nur) auf eine Phasensynchronisierung bezüglich einer DS-Frequenz oder -Periodizität, sondern tatsächlich auf eine absolutes zeitliches Verhältnis der jeweiligen Pulsflanken bzw. Teilpulse zueinander.

Durch die Funkenstreckenfreiheit von Pulsgenerator und Resonator sind diese praktisch jitterfrei. "Jitterfrei" ist hierbei so zu verstehen, dass der zeitliche Jitter bezüglich des jeweiligen Elements deutlich kleiner als 40ps, zum Beispiel kleiner 20ps oder kleiner 10ps oder kleiner 5ps oder kleiner 1ps ist.

Durch die Rückkopplung der Messsignale (eines vorherigen Gesamtpulses bzw. dessen Teilpulsen) auf das Triggermodul ist das Array dazu eingerichtet, die Triggerfolge anhand der rückgekoppelten Messsignale auf die gewünschte Sendefolge hin zu überprüfen / zu überwachen und/oder anzupassen. Insbesondere ist es so möglich, durch die Rückkopplung ein Delay bzw. verschiedene Delays der Einzelmodule zu korrigieren bzw. zu kompensieren. Delay ist hierbei die Laufzeit zwischen Erzeugen / Eintreffen des Triggersignals und Erzeugung / Abstrahlung des Teilpulses, also nicht der Jitter.

Durch die Anpassung / Veränderung / Korrektur der Triggerfolge ist es zum Beispiel möglich, Delay- also Laufzeitunterschiede zu kompensieren, die zum Beispiel durch zeitliche Drift von Komponenten in den Einzelmodulen wegen Temperatureinflüssen, Alterung usw. auftreten. Auch wenn keine Veränderungen an der Triggerfolge notwendig sind, da die Teilpulse bereits in der gewünschten zeitlichen Sendefolge abgestrahlt werden, ist dennoch eine Verifizierung bzw. Überwachung durch Überprüfung der Messsignale möglich.

Insgesamt ist somit eine verbesserte Erzeugung eines HPEM-DS-Gesamtpulses ermöglicht.

In einer bevorzugten Ausführungsform enthält das Triggermodul einen Delaygenerator. Der Delaygenerator ist dazu eingerichtet, auf ein Startsignal hin die Triggersignale für jedes der Einzelmodule auszugeben. Die Ausgabe erfolgt hierbei nach einer individuell veränderbaren Delayzeit für jedes der Einzelmodule. Mit anderen Worten ist der DelayGenerator also programmierbar bzw. veränderbar. Die Gesamtheit der Delayzeiten bestimmt bzw. stellt die Triggerfolge dar. Der Delaygenerator verzögert also ggf. das Startsignal je nach Programmierung bzw. Konfiguration, um individuelle Triggersignale zu schaffen, so dass diese die zeitliche Triggerfolge aufweisen und gemäß dieser vom Triggermodul ausgegeben werden. Somit ist die zeitliche Triggerfolge der Triggersignale besonders einfach zu erzeugen und auch zu verändern.

In einer bevorzugten Variante dieser Ausführungsform ist wenigstens eine, insbesondere mehrere oder alle, der Delayzeiten zeitlich adaptiv in Abhängigkeit der rückgekoppelten Messsignale gewählt. Mit anderen Worten wird abhängig von der Rückkopplung der Messsignale die Delayzeit so angepasst, dass sich durch Auslösen der Einzelmodule anhand der zeitlichen Triggerfolge unter Berücksichtigung individueller und eventuell unterschiedlicher Laufzeiten in den Einzelmodulen die Teilpulse anhand der gewünschten zeitlichen Sendefolge einstellen. Mit anderen Worten kann durch die Rückkopplung eine Regelung der zeitlichen Sendefolge erreicht werden, um möglichst genau und dauerhaft jeweilige Gesamtpulse als Summe der Teilpulse in der gewünschten Sendefolge erzeugen zu können.

In einer bevorzugten Ausführungsform ist wenigstens einer, insbesondere mehrere oder alle, der Pulsgeneratoren ein Halbleiter-Pulsgenerator. Halbleiter-Pulsgeneratoren sind aufgrund ihrer Ausführung mit Hilfe von Halbleitern besonders jitterarm bzw. im obigen Sinne jitterfrei, was zu einer zeitlich hochgenauen Pulserzeugung der Quellpulse führt.

In einer bevorzugten Ausführungsform ist wenigstens einer, insbesondere mehrere oder alle, der Resonatoren ein jeweiliger Halbleiter-Resonator. Die Ausführungen zum Halbleiter-Pulsgenerator gelten hier sinngemäß.

In einer bevorzugten Ausführungsform enthält oder ist wenigstens einer, insbesondere mehrere oder alle, der Resonatoren ein jeweiliges Pi-Filter. Durch Pi-Filter können Resonatoren besonders einfach und hochqualitativ aufgebaut werden.

In einer bevorzugten Ausführungsform weist wenigstens einer, insbesondere mehrere oder alle, der Resonatoren eine dem Pulsgenerator zugewandte Eingangsimpedanz auf, die niedriger als eine der Antenne zugewandte Ausgangsimpedanz ist. Insbesondere ist die Eingangsimpedanz kleiner der Hälfte, eines Drittels, eines Viertels oder eines Fünftels der Ausgangsimpedanz. Durch eine entsprechende Impedanzanpassung lassen sich hinsichtlich der Erzeugung der Teilpulse aus dem Quellpuls besonders vorteilhafte Einzelmodule schaffen.

In einer bevorzugten Ausführungsform ist wenigstens einer, insbesondere mehrere oder alle, der Resonatoren auf einer Platine ausgeführt. Der Resonator ist dabei in Streifenleitertechnik ausgeführt. Somit lassen sich besonders einfach und kostengünstig entsprechende Resonatoren herstellen.

In einer bevorzugten Variante dieser Ausführungsform ist in wenigstens einem, insbesondere mehreren oder allen, der Einzelmodule mit solchen Platinen der Richtkoppler auf der jeweiligen Platine des Resonators integriert. Somit entsteht eine besonders kompakte Bauweise des jeweiligen Einzelmoduls.

Die Aufgabe der Erfindung wird auch gelöst durch ein Verfahren gemäß Patentanspruch 10. Dieses dient bzw. ist eingerichtet zum Betreiben des erfindungsgemäßen Arrays. Bei dem Verfahren stellt das Triggermodul für den jeweiligen der Gesamtpulse die Triggersignale bereit. Es tut dies anhand des wenigstens einen der rückgekoppelten Messsignale. Es stellt die Triggersignale in der zeitlichen Triggerfolge bereit und zwar derart, dass die Teilpulse in der gewünschten zeitlichen Sendefolge zueinander erzeugt bzw. abgestrahlt werden.

Das Verfahren und zumindest ein Teil dessen möglicher Ausführungsformen sowie die jeweiligen Vorteile wurden sinngemäß bereits im Zusammenhang mit dem erfindungsgemäßen Array erläutert. Insbesondere bilden also die oben im Zusammenhang mit dem Array genannten bevorzugten Ausführungsformen auch bevorzugte Ausführungsformen des Verfahrens.

Die Erfindung beruht auf folgenden Erkenntnissen, Beobachtungen bzw. Überlegungen und weist noch die nachfolgenden bevorzugten Ausführungsformen auf. Diese Ausführungsformen werden dabei teils vereinfachend auch "die Erfindung" genannt. Die Ausführungsformen können hierbei auch Teile oder Kombinationen der oben genannten Ausführungsformen enthalten oder diesen entsprechen und/oder gegebenenfalls auch bisher nicht erwähnte Ausführungsformen einschließen.

Gemäß der Erfindung ergibt sich also insbesondere ein jitterfreier HF-Resonator in Streifenleitertechnik mit integriertem Richtkoppler zur Korrektur der zeitlichen Genauigkeit bei Halbleiter-HPEM-Arrays.

Es ergibt sich insbesondere die Kombination eines schnellen, zeitscharfen Halbleiter-Pulsgenerators mit einem funkenstreckenfreien und damit jitterfreien HF-Resonator zur Erzeugung eines DS-Pulses und einem Richtkoppler als Rückkopplungspfad. Dadurch kann bei Array-Betrieb mehrerer solcher Einzelmodule die Synchronsiation dieser Module vermessen und bei Bedarf korrigiert werden.

Die Erfindung beruht auf folgenden Überlegungen:
Grundsätzlich kann die abgestrahlte Leistung und damit die Reichweite eines HPEM-Systems (z.B. auf Basis abgestrahlter DS-Pulse) über den Antennengewinn und/oder über höhere Sendeleistung gesteigert werden. Ein höherer Antennengewinn steigert die Größe der Antenne oft überproportional; dies kann unerwünscht oder nicht mehr sinnvoll umsetzbar sein. Die HF-Leistung einer Sendeeinheit, hier aus einem DS-Resonator, der mit einem Hochspannungspuls (z.B. aus einem Marxgenerator, aber auch aus einem einzelnen Halbleiter-Pulsgenerator) geladen wird, kann ebenso technisch begrenzt sein.

Die abgestrahlte Leistung kann bekannterweise auch über Antennenarrays gesteigert werden. Bei gleichem Antennengewinn eines Arrays aus Einzelantennen (bei gleicher Frequenz, ob Dauerstrich oder DS) ist zwar die gleiche Gesamt-Antennenapertur notwendig, aber die Bautiefe des Antennenarrays kann sich deutlich, oft auch überproportional, reduzieren. Zusätzlich kann jede Einzelantenne im Array mit einer Pulssendeanlage aus Resonator und Hochspannungserzeugung versorgt werden.

Es werden damit zwar mehrere Resonatoren und Pulsgeneratoren, z.B. bei N Antennen bis zu N Resonatoren und Pulsgeneratoren, benötigt, aber diese können mit jeweils kleinerer Ausgangsspannung insgesamt die gleiche Gesamt-Sendeleistung bereitstellen. Wenn die Spannungsamplitude eines einzelnen Pulsgenerators technisch limitiert ist, kann mit N Pulsgeneratoren eventuell sogar eine höhere Gesamt-Sendeleistung und damit mehr Reichweite bei einem solchen Array realisiert werden, als dies bei einem Einzelsystem mit gleichem Antennengewinn wie der Gesamtgewinn des Arrays technisch möglich wäre.

Marxgenerator-betriebene HPEM-Systeme haben im freilaufenden Betrieb keinerlei zeitliche Schärfe, und auch getriggerte Marx-Generatoren haben oft eine ungenügende Zeitschärfe für den Array-Betrieb, zumindest bei relevanten Frequenzen von mehreren 100 MHz bis in den unteren GHz-Bereich.

Halbleiter-Pulsgeneratoren können teilweise mit Zeitschärfen (Jitter) von 50 ps und weniger angesteuert und betrieben werden. Durch funkenstreckenbetriebene Resonatoren wird in der Regel diese zetliche Schärfe aber wieder verschlechtert.

Grundidee der Erfindung ist es, Halbleiter-Pulsgeneratoren und Resonatoren derart zeitgenau betreiben bzw. individuelle Zeitverzüge korrigieren zu können, dass hieraus ein Array mehrerer Antennen und mehrerer Resonatoren mit mehreren Generatoren gebildet werden kann. Für die notwendige Erfassung der individuellen Zeitverzüge muss ein Rückkanal verfügbar sein, um diese Zeitverzögerungen (also Delay, nicht Jitter) vermessen zu können. Nur bei bekannten Verzögerungen bei gleichzeitig extrem kleinen Jitter können diese dann als Korrekturgrößen verwendet werden.

Die Erfindung beruht auf folgenden Überlegungen: Bei leistungsstarken HPEM-Systemen könnten mehrere Wege beschritten werden,um die einzelnen Resonatoren in einem Array möglichst zeitgenau zu betreiben.

So könnten mehrere Resonatoren mit einem gemeinsamen Marx-Generator betrieben werden, um die Leistung und damit die Reichweite durch möglichst gleichzeitiges Zünden der Resonatoren zu steigern. Die Marxgeneratoren benötigten zum Erzielen guter Zeitschärfe der Resonatoren jedoch höhere Spannungen als auch deutlich höhere Energiewerte, als sich dies aus dem Energiebedarf für einen Resonator, hochgerechnet auf alle Resonatoren im Array, linear schließen ließe.

Da aber bei Halbleiterpulsgeneratoren weitere Spannungssteigerungen einen sehr hohen Aufwand bedeutet, ist dieser Weg für Halbleitergeneratoren nur begrenzt sinnvoll. Der Weg ist jedoch auch nicht notwendig, zumal diese Halbleitergeneratoren im Gegensatz zu Marx-Generatoren sehr zeitscharf z.B. im Bereich von 50 ps und geringer steuerbar sind.

Schnelle Halbleiter-Pulsgeneratoren erzeugen im Wesentlichen einen unipolaren Hochspannungspuls. Ist der Puls schnell genug, kann dieser direkt an eine Antenne geleitet werden. Sehr breitbandige Antennen differenzieren den Eingangspuls sehr exakt (im Sinne einer zeitlichen Ableitung), so dass ein bipolarer Puls ohne zusätzliches Nachschwingen abgestrahlt wird.

Soll jedoch ein länger schwingender DS-Pulszug erzeugt und abgestrahlt werden, bietet sich an, zwischen dem schnellen Halbleiter-Pulsgenerator und der Antenne einen HF-Resonator zwischenzuschalten. Dieser HF-Resonator kann funkenstreckenbasiert sein, womit das Gesamtsystem dann als Halbleiter-Hybrid-Systembezeichnet werden könnte. "Hybrid" bezeichnet hierbei die Kombination der funkenstreckenfreien, da halbleiterbasierten Pulserzeugung mit der funkenstreckenbasierten DS-Pulserzeugung im Resonator.

Denkbar sind aber auch funkenstreckenfreie Resonatoren. Diese können auf Basis von Leitungen wie Koaxialleitungen erstellt werden. Frequenzbestimmend können hierbei kurzgeschlossene Stichleitungen eingebaut werden, wie diese auch als Filterschaltungen bekannt sind. Statt Koaxialleitungen können die in der Funktion identischen Resonatorkreise auch als Streifenleitungsstrukturen auf Leiterkarten (Platine) gebaut werden. Vorteil ist das einfache Design, aber auch die größere Variabilität der Eingangs-und Ausgangsimpedanzen, welche mathematisch bei Koaxialleitungen sehr begrenzt sind.

DS-Resonatoren auf Leiterkartenbasis könnten beispielsweise als sogenannte Pi-Filter ausgeführt werden.

Richtkoppler sind in der HF-Technik bekannte Bauelemente, die in Bauarten der Koaxialtechnik, als Wellenleiter, als Streifenleiter auf Leiterkarten oder diskret für Leiterplattenmontage realisiert sein können.

Denkbar ist es, Resonatoren als auch Richtkoppler in Streifenleitungstechnik zu realisieren. Die Richtkoppler in solchen Kreisen werden beispielsweise zur Phasenkorrektur eingesetzt.

Die Erfindung beruht auf folgender Grundidee:
Es wird insbesondere ein schneller, zeitlich exakt steuerbarer Halbleiterpulsgenerator mit einem DS Resonator auf z.B. Leiterkartenbasis (in Streifenleiter-Design) kombiniert. Dieser Resonator wird wiederum mit einem Richtkoppler, z.B. ebenfalls in Streifenleiterdesign oder aus disktreten Bauteilen realisiert, kombiniert. Der Richtkoppler koppelt möglichst wenig Leistung aus, beispielsweise -20, -30 dB oder -40 dB, um möglichst kleine Spannungsamplituden zu erhalten. Der Resonator als auch der Richtkoppler sind praktisch jitterfrei, es gibt keine jitter behafteten Bauteile wie z.B. Funkenstrecken. Über den Richtkoppler kann ein Rückkanal geschaffen werden, mit dem die Laufzeiten von der Ansteuerung des Halbleitergenerators bis zum Pulsausgang messtechnisch mit einem schnellen Oszilloskop erfasst und bestimmt werden können.

Resonatoren in koaxialer Technik sind in den realisierbaren Impedanzen begrenzt. Für die gewünschte Anwendung, aus einem unipolaren Puls, ob aus einem Marx-Generator oder aus einem Halbleiter-Pulsgenerator, einen bipolaren und nachschwingenden DS-Puls zu erzeugen, ist eine geringe Eingangsimpedanz von Vorteil. Bei gleicher Eingangs- wie Ausgangsimpedanz wäre die Ausgangsspannung gegenüber der Eingangsspannung deutlich reduziert. Der längere, bipolare Puls muss sich aus der Energie des unipolaren Eingangspulses bilden, damit muss ein längerer Puls eine geringere Amplitude aufweisen. Nur bei deutlich unterschiedlichen Impedanzen - hierbei muss die Eingangsimpedanz deutlich unter der Ausgangsimpedanz von z.B. 50 Ohm liegen - kann sich eine Spannungsamplitude am Ausgang ausbilden, die der Spannungsamplitude am Eingang in etwa entspricht oder der zumindest nahekommt. Diese geringe Eingangsimpedanz - z.B. 12,5 Ohm, 10 Ohm oder noch geringer, muss jedoch der Halbleiter-Generator treiben können.

Die Einheit aus Halbleitergenerator, Resonator unterschiedlicher Impedanz am Ein- und Ausgang und integriertem Richtkoppler, wird noch mit einer geeigneten Antenne kombiniert und im Folgenden Einzelmodul genannt.

Ein derartiges Einzelmodul kann verfielfacht werden, um ein Array zu bilden. Über die Erfassung aller Rückkanäle aus allen Richtkopplern können die individuellen Verzögerungen (Delays) vermessen und beispielsweise mit handelsüblichen, programmierbaren Delay-Generatoren, die für die Ansteuerung der Einzelmodule verwendet werden, korrigiert werden. Damit kann ein Array aus N (oder NxM) Einzelmodulen synchron betrieben werden. Auch eine verzögerte Ansteuerung im Sinne eines Phased Arrays ist damit realisierbar.

Hierdurch ergeben sich folgende Vorteile:
Die bisherigen DS-Resonatoren, die extrem kurze, gedämpfte Sinuspulse erzeugen und in der Regel auch direkt abstrahlen, sind zumeist funkenstreckenbasiert. Diese könnten eventuell auch mit Richtkopplern kombiniert werden, jedoch weisen die Funkenstrecken in sich einen kleinen, aber für die HF-Frequenz relativ großem Jitter von mehreren 100 ps bis ns auf, so dass mit der Vermessung des Delays eines individuellen Pulses keine zeitliche Vorhersage für den folgenden Puls möglich ist. Damit sind Laufzeitkorrekturen nicht möglich.

Durch die Kombination eines Resonators in Streifenleitertechnologie, der ohne Funkenstrecken auskommt und damit sozusagen jitterfrei ist, mit einem Richtkoppler kann die individuelle Durchlaufzeit der Gesamtkette eines Einzelsystems aus Halbleiterpulsgenerator, Resonator und Antenne, welche auch keinen Jitter erzeugt, vermessen werden. Die Delay-Werte mehrerer Einzelsysteme können gegenseitig z.B. über programmierbare Delay-Generatoren ausgeglichen werden. Damit können alle Einzelsysteme gleichzeitig betrieben werden, d.h., die Einzelmodule strahlen gleichzeitig, nicht nur phasenrichtig, die gleichen Pulse ab, die sich im Array konstruktiv überlagern.

Resonatoren in koaxialer Technik sind wie bereits beschrieben in den realisierbaren Impedanzen sehr begrenzt. Diese Begrenzung können Resonatoren in Streifenleitertechnik umgehen, da sich auch sehr kleine Werte der Eingangsimpedanz realisieren lassen.

Grundidee der Erfindung ist auch die beschriebene Kombination des Resonators in Streifenleitungstechnik, welcher beispielsweise eine deutlich kleinere Eingans- wie Ausgangsimpedanz besitzt, mit einem Richtkoppler auf der gleichen Platine zur exakten zeitlichen Messung der Gesamt-Laufzeiten (Delay) im jeweiligen Einzelmodul. Diese Messgröße ermöglicht erst die Korrektur von einzelnen Delays der Einzelsysteme und damit die Synchronisierung eines Arrays.

Gemäß der Erfindung wird insbesondere ein zeitscharfer Halbleiter-Pulsgenerator mit einem praktisch jitter-freien Resonator in Streifenleitungstechnik, welcher beispielsweise eine deutlich kleinere Eingans- als Ausgangsimpedanz besitzt, und einem Richtkoppler kombiniert und das Gesamt-Delay nicht als Phase, sondern als Absolut-Zeit über den Messkanal des integrierten Richtkopplers erfasst. Das Gesamt-Delay kann als Korrekturgröße verwendet werden, um mehrere Einzelsysteme im Array-Verbund synchron betreiben zu können, bzw. als Phased-Array steuern zu können.

Ein bevorzugtes Ausführungsbeispiel ist dieKombination von zwei (bzw. bei Funktion auch beliebig vieler) Einzelsystemen aus jeweils einem Halbleiter-Pulsgenerator mit einem praktisch jitter-freien Resonator in Streifenleitungstechnik unterschiedlicher Impedanzen am Ein- und Ausgang, kombiniert mit einem Richtkoppler. Dem Resonator nachgeschaltet wird jeweils eine Antenne. Der Richtkoppler speist einen Rückkanal zur Messung der individuellen Laufzeit zwischen Trigger-Puls zur Ansteuerung des Halbleiter-Pulsgenerators und dem Ausgang am Richtkoppler. Bei zwei oder mehr Elnzelsystemen ist auch die Erfassung der beiden Richtkoppler-Signale und deren zeitlicher Unterschied ausreichend. Aus diesen Zeitunterschieden kann eine Korrekturzeit bestimmt, und diese in einen mehrkanaligen Delaygenerator (mindestens so viele Kanäle wie Einzelsysteme) eingegeben werden, welcher die jeweiligen Halbleiter-Pulsgeneratoren ansteuert. Damit kann das Array synchronisiert werden, und die abgestrahlte Feldstärke der beiden (oder mehr) Antennen überlagert sich konstruktiv in Hauptrichtung des Antennenarrays.

Fraglich könnte sein, ob ein Rückkanal verfügbar sein muss, denn eine einmalige Kalibrierung könnte ausreichen. Denkbar wäre damit ein vereinfachter Systemaufbau mit einmaliger Vermessung und Abgleich der Kanäle.

Bei einem absolut zeitstabilen System bzw. Pulsgenerator könnte eine einmalige Kalibrierung tatsächlich ausreichend sein. Reale Pulsgeneratoren dürften jedoch zeitliche Drifts (Temperaturdrift, Alterung etc.) aufweisen. Daher ist der Rückkanal zum Ausgleich von Drifts, Alterung etc., aber auch zur Verifizierung und Überwachung sinnvoll.

Fraglich könnte auch sein, wie ein Pi-Filter, der ein integrales Systemelement ist, ausgeführt ist.

Pi-Filter in Leistungsstruktur werden hier als aus der Praxis bekannt angenommen. Gemäß der Erfindung hat der Pi-Filter nicht mehr gleiche Impedanz am Ein- und Ausgang (z.B. 50 Ohm), sondern ist am Eingang extrem niederimpedant (z.B. 12,5 Ohm), bei gleichzeitig 50 Ohm am Ausgang.

Fraglich könnte auch sein, wie der insbesondere sehr breitbandige Richtkoppler ausgeführt ist und wie Dispersion verhindert wird, sodass das Messsignal selbst nicht beeinflusst wird.

Der Richtkoppler kann z.B. ein handelsübliches Zukaufteil sein. Bei -20 dB (oder höherer) Auskopplung dürften keine Rückwirkungen zu erwarten sein, auch keine wesentliche Dispersion. Entscheidend ist das Erkennen der ersten Pulsflanke.

Fraglich könnte auch sein, welche Genauigkeit nötig ist und welche Genauigkeit erreicht werden kann, und welcher Jitter im Sinne des Begriffes "praktisch jitterfrei" noch tolerierbar ist.

Die Pulsgeneratoren können in der der Praxis derzeit auf 40 ps genau angesteuert werden. Dies ist gut ausreichend für Frequenzen von 2 bis 3 GHz. Die angegebenen 40 ps sind jedoch bereits die Grenze der aktuell verwendeten Messtechnik. Es ist davon auszugehen, dass der Resonator aus Pi-Filter nur Leitungslaufzeiten besitzt, und mögliche Jitter weit unter den aktuellen 40 ps der Generatoren liegen dürften. In diesem Sinne ist die Angabe "praktisch jitterfrei" zu vestehen.

Weitere Merkmale, Wirkungen und Vorteile der Erfindung ergeben sich aus der nachfolgenden Beschreibung eines bevorzugten Ausführungsbeispiels der Erfindung sowie den beigefügten Figuren. Dabei zeigen, jeweils in einer schematischen Prinzipskizze:

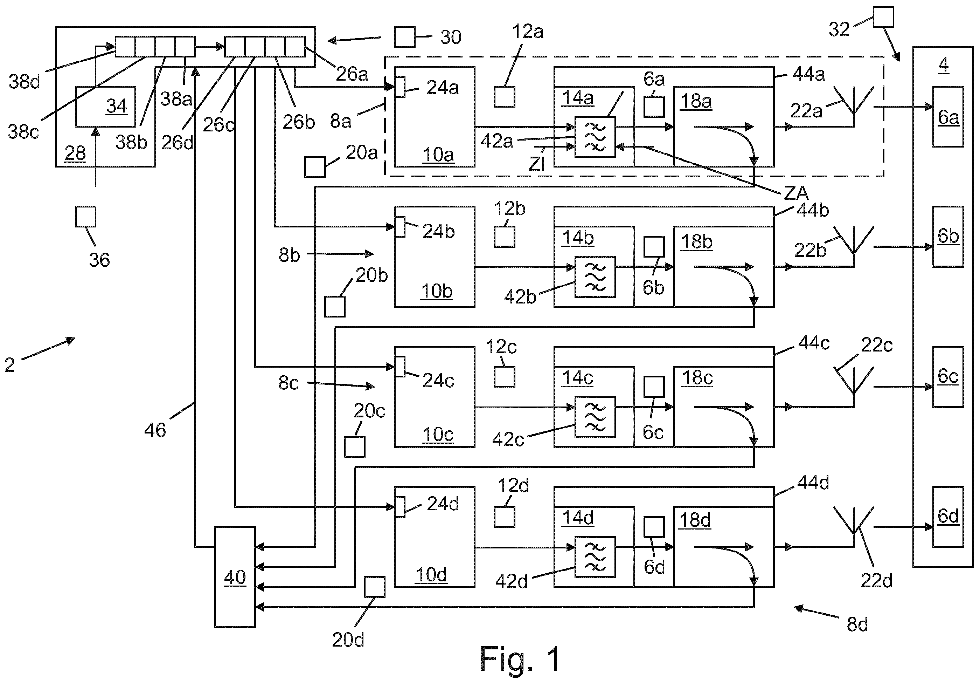

- Figur 1: ein Array zur Aussendung eines HPEM-DS-Gesamtpulses mit vier Einzelmodulen.
Figur 1 zeigt ein Array 2, welches zur Aussendung eines HPEM-DS-Gesamtpulses 4 dient. Der Gesamtpuls 4 wird anhand von vier sich überlagernden bzw. addierenden HPEM-DS-Teilpulsen 6a-d bzw. deren Summe erzeugt.

Das Array 2 enthält vier parallel geschaltete Zweige in Form von Einzelmodulen 8a-d (nur für das Einzelmodul 8a gestrichelt angedeutet). Jedes der Einzelmodule 8a-d enthält eine Reihenschaltung von Komponenten. Die Reihenschaltung beginnt - in Signal- bzw. Flussrichtung - mit einem funkenstreckenfreien Pulsgenerator 10a-d, welcher der Erzeugung eines jeweiligen Quellpulses 12a-d dient. Die Pulsgeneratoren 10a-d sind Halbleiter-Pulsgeneratoren.

In der Reihenschaltung folgt sodann jeweils ein funkenstreckenfreier Resonator 14a-d, welcher einen jeweiligen Teilpuls 6a-d aus dem jeweiligen Quellpuls 12a-d formt. Die Resonatoren 14a-d sind Halbleiter-Resonatoren.

Die jeweilige Reihenschaltung wird weiter fortgeführt durch einen Richtkoppler 18a-d, welcher einen unwesentlichen Teil des Teilpulses 6a-d als Messsignal 20a-d des Teilpulses 6a-d aus der Reihenschaltung auskoppelt bzw. abzweigt. Die Reihenschaltung endet mit einer jeweiligen Antenne 22a-d, welche mit dem Teilpuls 6a-d (dessen verbleibendem Großteil abzüglich des unwesentlichen Anteils "Messsignal 20a-d") gespeist ist und diesen in Form elektromagnetischer Strahlung aussendet.

Die vier Teilpulse 6a-d überlagern bzw. addieren sich dann zum Gesamtpuls 4.

Die Resonatoren 14a-d enthalten hierbei jeweils ein Pi-Filter 42a-d. Die Resonatoren 14a-d weisen außerdem eine dem jeweiligen Pulsgenerator 10a-d zugewandte Eingangsimpedanz ZI auf, die kleiner der Ausgangsimpedanz ZA ist, welche jeweils der Antenne 22a-d zugewandt ist, hier ein Viertel der Ausgangsimpedanz ZA beträgt. Dies ist exemplarisch lediglich für das Einzelmodul 8a dargestellt.

Außerdem sind sämtliche Resonatoren 14a-d jeweils auf einer Platine 44a-d in Streifenleitertechnik ausgeführt. Die Richtkoppler 18a-d sind auf der jeweiligen Platine 44a-d, also zusammen mit dem jeweiligen Resonator 14a-d, integriert.

Jedes der Einzelmodule 8a-d weist einen Triggereingang 24a-d zum Empfang eines jeweiligen Triggersignals 26a-d auf. Jedes der Triggersignale 26a-d dient dazu, die Erzeugung eines jeweiligen Quellpulses 12a-d im Pulsgenerator 10a-d zu initiieren.

Das Array 2 enthält weiterhin ein Triggermodul 28, das die Triggersignale 26a-d als zeitliche Triggerfolge 30 bereitstellt bzw. an die Einzelmodule 8a-d ausgibt. Die Triggerfolge 30 der Triggersignale 26a-d ist derart ausgestaltet, dass die Teilpulse 6a-d in einer gewünschten zeitlichen Sendefolge 32, also in entsprechender absoluter zeitlicher Korrelation zueinander, abgestrahlt werden. Insbesondere werden alle vier Teilpulse 6a-d gleichzeitig von den Resonatoren 14a-d ausgegeben und damit auch von den Antennen 22a-d abgestrahlt (also Gleichzeitigkeit der ersten Flanken der Teilpulse 6a-d).

Das Triggermodul 28 enthält einen Delaygenerator 34, welcher programmierbar bzw. veränderbar ist. Dieser ist dazu eingerichtet, ein Startsignal 36 zu empfangen und daraufhin für jedes der Einzelmodule 8a-d das jeweilige Triggersignal 26a-d nach einer jeweils individuell veränderbaren Delayzeit 38a-d (zeitliche Verzögerung zum Startsignal 36) auszugeben. Die Programmierbarkeit bzw. Veränderbarkeit des Delaygenerators 34 ist durch die Veränderbarkeit der Delayzeiten 38a-d gegeben.

Die Messignale 20a-d sind auf eine Messeinheit 40, hier ein Digitaloszilloskop, rückgeführt. Informationen über die Messignale 20a-d (hier über deren zeitlichen Bezug zueinander) werden von dort über einen Referenzkanal 46 an das Triggermodul 28 bzw. den Delaygenerator 34 geführt.

Die Delayzeiten 38a-d sind aufgrund der Information zeitlich adaptiv in Abhängigkeit der rückgekoppelten Messsignale 20a-d gewählt bzw. werden die Delayzeiten 38a-d so angepasst, dass sich die gewünschten zeitlichen Zusammenhänge zwischen den Teilpulsen 6a-d (und damit Messsignalen 20a-d) einstellen. So entsteht also eine Rückkopplung der Messsignale 20a-d auf das Triggermodul 28, um die Programmierung des Delaygenerators 34, also die Einstellung der Delayzeiten 38a-d zu bewerkstelligen.

Beim Betrieb des Arrays 2 stellt das Triggermodul 28 für einen jeweiligen auszusendenden Gesamtpuls 4 die vier Triggersignale 26a-d anhand der vier rückgekoppelten Messsignale 20a-d (des vorher ausgesendeten Gesamtpulses 4) in der zeitlichen Triggerfolge 30 derart bereit, dass die hieraus resultierenden bzw. erzeugten Teilpulse 6a-d in der gewünschten zeitlichen Sendefolge 32 zueinander abgestrahlt werden und sich in gewünschter Weise zu dem Gesamtpuls 4 addieren bzw. überlagern.

Dabei werden gegebenenfalls anhand des Delaygenerators 34 bzw. dessen Programmierung Delayzeiten 38a-d für die vier Triggersignale 26a-d so gewählt bzw. geändert, dass in Anbetracht sämtlicher Laufzeiten innerhalb der Einzelmodule 8a-d die Teilpulse 6a-d zeitrichtig im Sinne der Sendefolge 32 einstellen bzw. erzeugt werden.

### Bezugszeichenliste

- 2: Array
- 4: Gesamtpuls
- 6a-d: Teilpuls
- 8a-d: Einzelmodul
- 10a-d: Pulsgenerator
- 12a-d: Quellpuls
- 14a-d: Resonator
- 18a-d: Richtkoppler
- 20a-d: Messsignal
- 22a-d: Antenne
- 24a-d: Triggereingang
- 26a-d: Triggersignal
- 28: Triggermodul
- 30: Triggerfolge
- 32: Sendefolge
- 34: Delaygenerator
- 36: Startsignal
- 38a-d: Delayzeit
- 40: Messeinheit
- 42a-d: Pi-Filter
- 44a-d: Platine
- 46: Referenzkanal

- ZI: Eingangsimpedanz
- ZA: Ausgangsimpedanz

## Patentansprüche

1. Array (2) zur Aussendung eines HPEM-DS-Gesamtpulses (4) als Summe von HPEM-DS-Teilpulsen (6a-d),
- mit mindestens zwei Einzelmodulen (8a-d), wobei jedes der Einzelmodule (8a-d) eine Reihenschaltung enthält aus
- einem funkenstreckenfreien Pulsgenerator (10a-d) zur Erzeugung eines Quellpulses (12a-d),
- einem funkenstreckenfreien Resonator (14a-d) zur Formung eines der Teilpulse (6a-d) aus dem Quellpuls (12a-d),
- einem Richtkoppler (18a-d) zur Auskopplung eines Teils des Teilpulses (6a-d) als Messsignal (20a-d), und
- einer Antenne (22a-d) zur Abstrahlung des Teilpulses (6a-d) als Teil des Gesamtpulses (4),
- wobei jedes der Einzelmodule (8a-d) einen Triggereingang (24a-d) zur Auslösung des jeweiligen Pulsgenerators (10a-d) anhand eines Triggersignals (26a-d) enthält,
- mit einem auf die Triggereingänge (24a-d) geführten Triggermodul (28), das dazu eingerichtet ist, für einen jeweiligen der Gesamtpulse (4) die Triggersignale (26a-d) anhand wenigstens eines der rückgekoppelten Messsignale (20a-d) in einer zeitlichen Triggerfolge (30) derart bereitzustellen, dass die Teilpulse (6a-d) in einer gewünschten zeitlichen Sendefolge (32) zueinander abgestrahlt sind.

2. Array (2) nach Anspruch 1,
**dadurch gekennzeichnet, dass**
das Triggermodul (28) einen Delaygenerator (34) enthält, der dazu eingerichtet ist, auf ein Startsignal (36) hin die Triggersignale (26a-d) für jedes der Einzelmodule (8a-d) nach einer individuell veränderbaren Delayzeit (38a-d) auszugeben.

3. Array (2) nach Anspruch 2,
**dadurch gekennzeichnet, dass**
wenigstens eine der Delayzeiten (38a-d) zeitlich adaptiv in Abhängigkeit der rückgekoppelten Messsignale (20a-d) gewählt ist.

4. Array (2) nach einem der vorhergehenden Ansprüche,
**dadurch gekennzeichnet, dass**
wenigstens einer der Pulsgeneratoren (10a-d) ein Halbleiter-Pulsgenerator ist.

5. Array (2) nach einem der vorhergehenden Ansprüche,
**dadurch gekennzeichnet, dass**
wenigstens einer der Resonatoren (14a-d) ein Halbleiter-Resonator ist

6. Array (2) nach einem der vorhergehenden Ansprüche,
**dadurch gekennzeichnet, dass**
wenigstens einer der Resonatoren (14a-d) ein Pi-Filter (42a-d) enthält

7. Array (2) nach einem der vorhergehenden Ansprüche,
**dadurch gekennzeichnet, dass**
wenigstens einer der Resonatoren (14a-d) eine dem Pulsgenerator (10a-d) zugewandte Eingangsimpedanz (ZI) aufweist, die niedriger als eine der Antenne (22a-d) zugewandte Ausgangsimpedanz (ZA) ist.

8. Array (2) nach einem der vorhergehenden Ansprüche,
**dadurch gekennzeichnet, dass**
wenigstens einer der Resonatoren (14a-d) in Streifenleitertechnik auf einer Platine (44a-d) ausgeführt ist.

9. Array (2) nach Anspruch 8,
**dadurch gekennzeichnet, dass**
mindestens einer der Richtkoppler (18a-d) auf der jeweiligen Platine (44a-d) integriert ist.

10. Verfahren zum Betreiben des Arrays (2) nach einem der vorhergehenden Ansprüche, bei dem das Triggermodul (28) für den jeweiligen der Gesamtpulse (4) die Triggersignale (26a-d) anhand des wenigstens einen der rückgekoppelten Messsignale (20a-d) in der zeitlichen Triggerfolge (30) derart bereitstellt, dass die Teilpulse (6a-d) in der gewünschten zeitlichen Sendefolge (32) zueinander abgestrahlt werden.
